# EUROPEAN PATENT SPECIFICATION

(11) **EP 3 940 702 B1**
(45) Date of publication and mention of the grant of the patent: **27.11.2024**
(21) Application number: 20382628.4
(22) Date of filing: 14.07.2020
(51) Int. Cl.: G11C 11/15, G11C 11/16, H10B 61/00, H10N 50/80, H10N 50/10

(54) **A MAGNETOELECTRIC DEVICE AND USES OF THE MAGNETOELECTRIC DEVICE**
MAGNETO-ELEKTRISCHE VORRICHTUNG UND VERWENDUNGEN DER MAGNETO-ELEKTRISCHEN VORRICHTUNG
DISPOSITIF MAGNÉTOÉLECTRIQUE ET UTILISATIONS DU DISPOSITIF MAGNÉTOÉLECTRIQUE

(43) Date of publication of application: 19.01.2022
(73) Proprietor: Universitat Autònoma de Barcelona, 08193 Bellaterra (ES); Institució Catalana de Recerca I Estudis Avançats, 08010 Barcelona (ES); Consejo Superior de Investigaciones Cientificas, 28006 Madrid (ES)
(72) Inventor: SORT VIÑAS, Jordi, 08193 BELLATERRA (ES); MENÉNDEZ DALMAU, Enric, 08193 BELLATERRA (ES); SIREUS, Veronica, 08193 BELLATERRA (ES); NICOLENCO, Aliona, 08193 BELLATERRA (ES); CIALONE, Matteo, 08193 BELLATERRA (ES); DE ROJAS III, Julius Caesar, 08193 BELLATERRA (ES); RIUS SUÑÉ, Gemma, 28006 MADRID (ES)
(74) Representative: Ponti & Partners, S.L.P

(56) References cited:
- JIANG M ET AL: "Electrochemical control of the phase transition of ultrathin FeRh films", APPLIED PHYSICS LETTERS, A I P PUBLISHING LLC, US, vol. 108, no. 20, 16 May 2016 (2016-05-16), XP012207848, ISSN: 0003-6951, [retrieved on 19010101], DOI: 10.1063/1.4950973
- NAVARRO-SENENT CRISTINA ET AL: "Electrolyte-gated magnetoelectric actuation: Phenomenology, materials, mechanisms, and prospective applications", APL MATERIALS, AMERICAN INSTITUTE OF PHYSICS, 2 HUNTINGTON QUADRANGLE, MELVILLE, NY 11747, vol. 7, no. 3, 6 March 2019 (2019-03-06), XP012242075, DOI: 10.1063/1.5080284

## Description

### FIELD OF THE INVENTION

The present invention generally relates, in a first aspect, to a magnetoelectric device adapted to undergo ON-OFF states and OFF-ON states magnetic transitions, and more particularly to a magnetoelectric device made to provide said transitions by ferromagnetic to/from antiferromagnetic transitions.

A second aspect of the present invention relate to different uses of the magnetoelectric device of the first aspect of the present invention, including a use for implementing a data security device, and uses for information and communications technologies, including neuromorphic computing and/or stochastic data storage and/or stochastic data processing.

### BACKGROUND OF THE INVENTION

To be at the forefront of advanced and sustainable economies in our modern society, it is not only crucial to develop breakthrough technologies but also to translate them into new products, processes and services. Increasing industrial competitiveness while fulfilling energy, environment, security and other related demands is a central objective, which is intrinsically linked to technological advances and, ultimately, to scientific progress. Internet and digital technologies are transforming our world at a vertiginous speed. Big Data is a clear example, challenging information technology to an unprecedented extent, not only in terms of storage capacity needs but also from processing speed, robustness/stability and energy-efficiency as well as confidentiality, integrity and data availability aspects. According to International Data Corporation (IDC) [*https:llwww.idc.com*/*about*]*,* Big Data is surpassing the €175 billion market in 2020 (€112 billion in 2016) and, by 2025, around 180 trillion GB of information will be generated [*https:*//*vww.forbes.comlsiteslgilpressl2017*/*01*/*20*/*6-predictions-for-the-203-billion-big-data-analytics-marketf#3b00b3572083*]*.* Regarding data security, a Wipro study reported that, based on public disclosures, more than 2.7 billion data files are being stolen every year, doubling the total amount of data breaches during the preceding year [*https:*//*www.wipro.com*/].

Information technology deals with the storage, retrieval and manipulation of data in electronic devices, such as computers. Computers share a common architecture, known as the Von Neumann architecture, based on a storage hierarchy approach and built around the central processing unit (CPU), which constitutes the electronic circuitry (*i.e.,* processor). Next to the CPU is located the so-called random-access memory (RAM), or primary memory, a sub-device which allows data items to be rapidly stored and manipulated. The mass storage sub-device (*e.g.,* the hard disk drive, HDD), designed to exclusively store large amounts of information in partial detriment of processing speed, is placed further away [D. A. Patterson, J. L. Hennessy, in Computer Organization and Design: The Hardware/Software Interface (5th edition, Elsevier Inc., Amsterdam, 2014*)*]. Nowadays, even though semiconductor-based RAMs, such as dynamic or static RAMs (DRAMs and SRAMs, respectively) are mainly used [*https:*//*techinsights.com*/]*,* magnetoresistive RAMs (MRAMs) are already on the market, foreseeing magnetically-actuated RAMs as the next generation of these primary memories. In contrast to dynamical and static memories, MRAMs are non-volatile, fast enough to compete with static RAMs, more power efficient and allow for higher storage densities. MRAM technology is based on spintronics (spin-based electronics), incorporating spin (*i.e.,* magnetism) as an additional degree of freedom to electronic charge [S. Bhatti et al., Spintronics based random access memory; a review, Mater. Today 20 (2017) 530-548]. The MRAM variant based on spin transfer torque (STT-MRAMs) is so far the most promising in terms of energy-efficiency [K. L. Wang et al., Low-power non-volatile spintronic memory: STT-RAM and beyond, J. Phys. D: Appl. Phys. 46 (2013) 074003].

Although the Von Neumann computer architecture has been widely and successfully used for more than five decades, further device scaling (computing volume and complexity scaling) is hindered due to power and data processing speed considerations. The time and energy spent transporting data between the memory and the processor (*i.e.,* along the communication bus) has become a bottleneck for new progress in the field. A new paradigm for data storage and processing, inspired by the operating principles of neurons in the brain, has emerged in recent years [C. D. James et al., A historical survey of algorithms and hardware architectures for neural-inspired and neuromorphic computing applications, Biol. Inspir. Cogn. Arc. 19 (2017) 49-64]. So-called "neuromorphic computing" is based on the assembly of a myriad of low-power electrically interconnected computing elements (neurons) and adaptive memory units (artificial synapses) which can operate in parallel via spikes and the generation of synaptic weights, outperforming traditional computer systems both in terms of capacity and speed. Both digital and analogic neuromorphically-engineered integration systems have been proposed. One of the most efficient geometric arrangements of computing elements is the use of crossbar arrays. Different types of physical devices and principles of operation have been proposed in order to operate each memory unit. Perhaps the most extended is resistive switching (memristor-based synaptic devices), which takes advantage of drastic changes in the electric resistance of two-terminal dielectric materials under the action of strong electric fields or currents [D. lelmini, H. S. Philip Wong, In-memory computing with resistive switching devices, Nat. Electron. 1 (2018) 333-343]. Such a change is non-volatile and reversible and it has been utilized in the so-called resistive-RAMs (RRAMs). Some drawbacks of this type of memories are: (i) relatively high energy dissipation, in the form of Joule heating effects, during writing or encoding of information, (ii) uncontrolled fluctuations which renders increased read error outputs, (iii) difficulties to program memristors with a negative synaptic weight (inhibitory postsynaptic potential) and (iv) lack of understanding of the physical mechanisms responsible for the drastic change in conductivity [R. Mishra et al., Oxygen-migration-based spintronic device emulating a biological synapse, Phys. Rev. Appl. 11 (2019) 054065]. Some of these drawbacks, as will be described below, can be overcome by using magnetoelectric, instead of resistive, memory units in voltage-driven MRAM architectures.

Returning to conventional (Von Neumann) computer architectures, data storage and manipulation rely on magnetic HDDs and either electrically- or magnetically-actuated RAMs, respectively [S. D. Bader, S. S. P. Parkin, Spintronics. Rev. Condens. Matter. Phys. 1 (2010) 71-88]. According to the International Roadmap for Devices and Systems [*https:*//*irds.ieee.org*/*editions*/*2018*]*,* the optimization of such devices is considered a long-term challenge in electronics. In particular, these systems are ultimately controlled by electric currents (*i.e.,* magnetic fields through electromagnetic induction and/or spin-polarized electric currents via STT), involving a significant energy waste by heat dissipation through the Joule effect. The energy needed to switch a memory unit in a toggle MRAM is around 1 pJ, while that in a STT-RAM is 10⁻¹ pJ. This is one and two orders of magnitude larger than the writing energy/bit in dynamic (DRAM) and static (SRAM) devices, respectively [H. Cai et al., High performance MRAM with spin-transfer-torque and voltage-controlled magnetic anisotropy effects, Appl. Sci. 7 (2017) 929].

Alternatively, electric field control of magnetism (by converse magnetoelectric effect) is a fundamentally different approach towards the implementation of ultralow-heat-dissipation memories (with writing energies/bit down to 10⁻⁶ pJ) [S. Manipatruni et al., Scalable energy-efficient magnetoelectric spin-orbit logic, Nature 565 (2019) 35-42]. In this case, voltage is applied through an insulating layer (with an infinite resistance) and, therefore, electrons remain virtually static (leakage current flowing across the structure is nearly zero). As a result, this type of memories is highly efficient from an energy consumption viewpoint. Recently, magnetoelectric approaches have been realized in numerous classes of materials and architectures where an efficient modulation of various parameters, such as coercivity, magnetic moment, magnetic anisotropy, remanent magnetization, exchange bias, topological spin structures, etc. has been achieved [C. Navarro-Senent et al., Electrolyte-gated magnetoelectric actuation: Phenomenology, materials, mechanisms, and prospective applications, APL Mater. 7 (2019) 030701*;* A. Molinari et al., Voltage-control of magnetism in all-solid-state and solid/liquid magnetoelectric composites, Adv. Mater. 31 (2019) 1806662]. Some of the reported effects, such as the modulation of magnetization with voltage, has been proposed for neuromorphic computing [R. Mishra et al., Oxygen-migration-based spintronic device emulating a biological synapse, Phys. Rev. Appl. 11 (2019) 054065]. However, most of the research done so far has been focused on continuous films. Magnetoelectric studies on ordered arrays of patterned structures, in which different voltages can be applied to different memory units, have not been performed so far and are essential to bridge fundamental research to marketable devices.

Electric-field control of magnetism has primarily relied on the following strategies: (i) the use of single-phase multiferroic materials with intrinsic magnetoelectric coupling [W. Eerenstein et al., Multiferroic and magnetoelectric materials, Nature 442 (2006) 759-765], (ii) electric charge accumulation in ferromagnetic metals [M. Weisheit et al., Electric field-induced modification of magnetism in thin-film ferromagnets, Science 315 (2007) 349-351*;_*A. Quintana et al., Voltage-induced coercivity reduction in nanoporous alloy films: a boost toward energy-efficient magnetic actuation. Adv. Funct. Mater. 27 (2017) 1701904*]* or semiconductors [H. Ohno et al., Electric-field control of ferromagnetism. Nature 408 (2000) 944-946] (*i.e.,* direct electric-field effect) and (iii) piezostrain-mediated effects through inverse magnetostriction in ferromagnetic/ferroelectric heterostructures [M. Liu et al., Giant electric field tuning of magnetic properties in multiferroic ferritelferroelectric heterostructures, Adv. Mater. 19 (2009) 1826-1831]. However, the implementation of these approaches in marketable devices, such as magnetoelectric random access memories (ME-RAMs) [M. Bibes, A. Barthélémy, Towards a magnetoelectric memory nature materials. Nat. Mater. 7 (2008) 425-426], is hampered by several factors. Intrinsic multiferroics are scarce and show weak magnetoelectric coupling [N. Izyumskaya et al., Oxides, oxides, and more oxides: High-κ oxides, ferroelectrics, ferromagnetics, and multiferroics, Crit. Rev. Solid State Mater. Sci. 34 (2009) 89-179]. Due to the limited electric-field screening length in metallic ferromagnetic materials (within the Thomas-Fermi screening length which is roughly 5 Å), electronic charging is only observed in ultrathin films (2-3 nm), thus imposing strong fabrication/processing challenges [I. V. Ovchinnikov, K. L. Wang, Theory of electric-field-controlled surface ferromagnetic transition in metals, Phys. Rev. B 79 (2009) 020402*(R)*]. Finally, strain-mediated artificial multiferroic ferromagnetic/ferroelectric heterostructures suffer from clamping effects with the substrate, severely limiting the achievable strains and, thus, the potential magnetic modulation, and yielding mechanical failure [Y. Wang et al., Multiferroic magnetoelectric composite nanostructures. NPG Asia Mater. 2 (2010) 61-68].

In recent years, voltage-induced ion motion in magnetic materials (magneto-ionics) has revolutionized electric-field control of magnetism, since this mechanism may allow for a voltage-driven modulation of magnetic properties to an extent not reached by any of the aforementioned magnetoelectric means. Magneto-ionics also overcomes some of the drawbacks of the other magnetoelectric mechanisms, such as the clamping effects or film thickness limitation. In some materials an applied electric field induces ion migration of, *e.g.,* O²⁻ [A. Quintana et al., Voltage-controlled ON-OFF ferromagnetism at room temperature in a single metal oxide film, ACS Nano. 12 (2018) 10291; S. Robbennolt et al., Electric Field Control of Magnetism in Iron Oxide Nanoporous Thin Films, ACS Appl. Mater. Interfaces. 11 (2019) 37338-37346*;* U. Bauer et al., Magneto-ionic control of interfacial magnetism, Nat. Mater. 14 (2015) 174-181*],* Li⁺ [Q. Zhang et al., Lithium-Ion Battery Cycling for Magnetism Control, Nano Lett. 16 (2016) 583-587*;* S. Dasgupta et al., Toward on and off magnetism: reversible electrochemistry to control magnetic phase transitions in spinel ferrites, Adv. Funct. Mater. 26 (2016) 7507-7515], H⁺ [A. J. Tan et al., Magneto-ionic control of magnetism using a solid-state proton pump, Nat. Mater. 18 (2019) 35-41*;* M. Gößler et al., Magneto-ionic switching of superparamagnetism, Small 15 (2019) 1904523*]* or F⁻ [S. Vasala et al., Reversible tuning of magnetization in a ferromagnetic Ruddlesden-Popper-type manganite by electrochemical fluoride-ion intercalation, Adv. Electron. Mater. 6 (2020) 1900974] back and forth between the material of interest and an ion source/sink, depending on the voltage polarity. Diffusion of ions is associated with a change in the oxidation state of the metal, thus leading to large changes in magnetization. In the extreme case, one can induce ON/OFF magnetic switching, generating (ON) or suppressing (OFF) ferromagnetism at will, with voltage [A. Quintana et al., Voltage-controlled ON-OFF ferromagnetism at room temperature in a single metal oxide film, ACS Nano. 12 (2018) 10291*;* A. Molinari et al., Voltage-Controlled On/Off Switching of Ferromagnetism in Manganite Supercapacitors, Adv. Mater. 30 (2018) 1703908].

So far, such an effect has been observed at room temperature in only a very limited number of systems, such as non-patterned continuous Co₃O₄ thin films [A. Quintana et al., Voltage-controlled ON-OFF ferromagnetism at room temperature in a single metal oxide film, ACS Nano. 12 (2018) 10291], for a magnetoelectric element which adopts the OFF state by becoming paramagnetic, and which are therefore not applicable to implement ME-RAMs.

ON-OFF ferromagnetism at low temperatures was also achieved in La_{0.74}Sr_{0.26}MnO₃ films by electrochemical (pseudo-capacitance) doping [A. Molinari et al., Voltage-Controlled On/Off Switching of Ferromagnetism in Manganite Supercapacitors, Adv. Mater. 30 (2018) 1703908]. Other complex oxide heterostructures, such as perovskite SrCoO_{3-δ} actuated through an ionic liquid gate, also require of low temperature (<225 K) to enable ON/OFF magnetic switching [N. Lu et al., Electric-field control of tristate phase transformation with a selective dual-ion switch, Nature. 546 (2017) 124-128]. High-temperature (>470 K) voltage-assisted oxidation of ultrathin (0.7 nm) Co layers in contact with GdOₓ underlayers has also been used to suppress magnetization [C. Bi et al., Reversible control of Co magnetism by voltage-induced oxidation, Phys. Rev. Lett. 113 (2014) 267202]. A maximum of up to 70% change of the magnetization has been observed in ZnFe₂O₄ films at room temperature by electrochemistry-driven Li-ion exchange [S. Dasgupta et al., Toward on and off magnetism: reversible electrochemistry to control magnetic phase transitions in spinel ferrites, Adv. Funct. Mater. 26 (2016) 7507-7515].

Full ON/OFF switching of the magnetization at room temperature in low-dimensional systems (in view of applications to miniaturized devices) remains rather elusive. For instance, it has been realized via Li⁺ intercalation/deintercalation in α-Fe₂O₃ nanoparticles loaded onto a Cu foil cathode in a lithium ion battery [Q. Zhang et al., Lithium-Ion Battery Cycling for Magnetism Control, Nano Lett. 16 (2016) 583-587]. During lithiation, the device becomes magnetized due to an electrochemical reaction between the iron oxide and Li⁺ which results in partial conversion of oxide into metallic Fe. The effect is fully reversed during the de-lithiation process. Yet, α-Fe₂O₃ particles larger than 1 µm undergo irreversible changes in magnetism and cannot sustain large lithium intercalation [Q. Zhang et al., Lithium-Ion Battery Cycling for Magnetism Control, Nano Lett. 16 (2016) 583-587*;* D. Larcher et al., Effect of Particle Size on Lithium Intercalation into α-Fe2O3, J. Electrochem. Soc. 150 (2003) A133-A139]. Remarkably, almost complete ON/OFF switching was recently reported for β-FeOOH nanoplatelets in an alkaline Li-based electrolyte at room temperature [M. Nichterwitz et al., Voltage-controlled on switching and manipulation of magnetization via the redox transformation of β-FeOOH nanoplatelets, J. Phys. D. Appl. Phys. 53 (2020) 084001] and in electrodeposited Fe naturally covered by a thin layer of FeO*ₓ* tested in aqueous KOH solution [K. Duschek et al., All-electrochemical voltage-control of magnetization in metal oxide/metal nanoislands, J. Mater. Chem. C. 6 (2018) 8411-8417]. In the former case, application of negative voltage results in the reduction of virtually non-magnetic β-FeOOH to metallic Fe giving rise to magnetization; however, the platelet nanostructure is collapsed after first voltage cycle and cannot be recovered anymore. In the latter case, a modulation of magnetization (up to 86 %) was achieved by applying moderate voltages. However, the presence of a ferrimagnetic component in the starting FeO*ₓ* material precludes initial OFF magnetism. In these examples, the low-dimensional materials under investigation have random shapes or are disposed randomly onto a surface, thus precluding their use in interconnected ordered memory arrays.

Besides magneto-ionics, strain-mediated converse magneto-electric effects have been sometimes used to induce large changes in the magnetic properties of materials. A drastic voltage-controlled ON-OFF ferromagnetism at room temperature has only been achieved by tuning the antiferromagnetic-to-ferromagnetic metamagnetic transition of FeRh thin films [R. O. Cherifi et al., Electric-field control of magnetic order above room temperature, Nat. Mater. 13 (2014) 345-351] or the superparamagnetic blocking temperature of Ni nanoparticles [H. K. D. Kim et al., Magnetoelectric control of superparamagnetism, Nano Lett. 13 (2013) 884-888], in both cases through the coupling to underlying ferroelectric substrates. Voltage has been also used to induce a reorientation of the magnetic easy-axis in arrays of dipolarly coupled elliptical FeGa dots (preserving coherent rotation modes of magnetization reversal) [H. Ahmad et al., Electric field control of magnetic states in isolated and dipole-coupled FeGa nanomagnets delineated on a PMN-PT substrate, Nanotechnology 26 (2015) 401001]. Transition from coherent rotation mode (*i.e.,* square hysteresis loops with two remanent magnetization states) to vortex-like hysteresis loops (with zero or virtually zero remanent magnetization) has been only predicted theoretically for a single dot [Q. Sheng et al., Phase diagrams of magnetic state transformations in multiferroic composites controlled by size, shape and interfacial coupling strain, AIP Adv. 7 (2017) 105221] and not demonstrated experimentally. Moreover, the case of an array of dots remains from theoretical and experimental viewpoints unexplored. It is, therefore, necessary to provide an alternative to the state of the art which covers the gaps found therein, by providing a magnetoelectric device which indeed induces ON-OFF magnetic switching at room temperature, of a kind which make it suitable for being used, among others, as a ME-RAM.

JIANG M ET AL: "Electrochemical control of the phase transition of ultrathin FeRh films",APPLIED PHYSICS LETTERS, A I P PUBLISHING LLC, US, vol. 108, no. 20, 16 May 2016 (2016-05-16) discloses a magentoelectrical element based on FeRh thin films.

### SUMMARY OF THE INVENTION

To that end, the present invention relates, in a first aspect, to a magnetoelectric device, comprising:
- a magnetoelectric element; and
- an electric voltage source configured and arranged to induce on said magnetoelectric element, at least at room temperature, ON-OFF states and OFF-ON states magnetic transitions, by applying or removing determined electric voltages, wherein at said ON state the magnetoelectric element shows permanent and net magnetization, i.e. ferromagnetism.

In contrast to the systems known in the prior art, in the system of the present invention, in a characterizing manner, the magnetoelectric element is configured and arranged to be, at said induced OFF state, completely antiferromagnetic or partially antiferromagnetic (*i.e.,* with some traces of ferromagnetism) but with a magnetization below 50 emu/cm³. This makes it suitable for implementing a ME-RAM.

As stated above, the magnetoelectric device of the first aspect of the present invention operates (*i.e.,* is made to undergo the ON-OFF and OFF-ON states magnetic transitions) at least at room temperature, which means that it is made to operate with no external o extrinsic applied additional heating or cooling, and specifically from room temperature up to a temperature below the Néel temperature of the antiferromagnetic element.

For a first main implementation, the magnetoelectric element and the electric voltage source are configured and arranged to induce the above mentioned ON-OFF states and OFF-ON states magnetic transitions by phase transformations caused by a voltage-driven ion migration mechanism.

For some embodiments of said first main implementation, the magnetoelectric element is made of an oxide or nitride of iron, nickel, ternary nickel-cobalt or ternary cobalt-manganese.

According to some of those embodiments, the magnetoelectric element is an iron oxide comprising, when no voltage is applied thereto, hematite, wüstite or a mixture of hematite and wüstite iron oxide phases (antiferromagnetic), and wherein the magnetoelectric element and the electric voltage source are configured and arranged to induce phase transformations including:
- for the ON state, metallic iron (ferromagnetic) and/or maghemite (ferrimagnetic) and/or magnetite (ferrimagnetic); and
- for the OFF state, said hematite and wüstite iron oxide phases, and no metallic iron, no magnetite and no maghemite or a rather small fraction of metallic iron and magnetite providing said magnetization below 50 emu/cm³ (in the form of superparamagnetic clusters).

For an embodiment of the first main implementation, the magnetoelectric element is in the form of a dense layer (*i.e.,* a non-porous layer) of thickness between 2 and 200 nm, and the magnetization device further comprises:
- an electrically conducting substrate or a substrate with an electrically conducting buffer/seed layer; and
- a top electrode configured and arranged to act as ion reservoir and/or electric contact.

According to different embodiments of the first main implementation, the electric voltage source is configured and arranged to applying the determined electric voltages to the magnetoelectric element for example via a condenser-like configuration, by means of other schemes, such as transistor-like configurations, in which case the magnetoelectric element would act itself as source and drain of current.

For a second main implementation of the magnetoelectric device of the first aspect of the present invention, the magnetoelectric device further comprises a ferroelectric substrate supporting the magnetoelectric element, and the magnetoelectric element and the electric voltage source are configured and arranged to induce said ON-OFF states and OFF-ON states magnetic transitions by reversal mode changes caused by a mechanism providing a voltage-driven piezostrain-mediated coupling between the ferroelectric substrate and the magnetoelectric element, wherein said reversal mode changes refer to changes from/to a ferromagnetic state with multi- or single-domain state, for said ON state, to/from a state with a closure domain with minimal squareness (M_{R}/M_{S}·100% where M_{R} is the remanent magnetization and Ms is the saturation magnetization) below 10% for said OFF state.

According to an embodiment of said second main implementation, the magnetoelectric element has an any form (e.g., oval, circular, square, rectangular...), the ferromagnetic state corresponds to either a multi- or a single-domain state (i.e., non-constricted hysteresis loop), and wherein said state with minimal squareness is a flux-closure domain structure where magnetization is symmetrically distributed in-plane with respect to the flux-closure domain structure core, allowing for a maximum remanent magnetization M_{R} of 10% of the saturation magnetization Ms in case the flux-closure domain structure core is offset from the magnetoelectric element centre.

Preferably, the above mentioned full-closure domain structure is a vortex or similar full-closure domain structure.

For an embodiment of the second main implementation, the electric voltage source is configured and arranged to apply said determined electric voltages perpendicularly (i.e., out-of-plane poling) to a surface of the ferroelectric substrate facing said magnetoelectric element and to the plane of the magnetoelectric element, for example via a condenser-like configuration, through which an in-plane voltage-induced strain is produced under the out-of-plane application of said determined electric voltages.

According to an embodiment of the second main implementation, the magnetoelectric element is made of a soft ferromagnetic material with a coercivity below 200 Oe having a large polycrystalline magnetostrictive constant λ above 100 ppm.

For a variant of said embodiment, said soft ferromagnetic material is a Fe-based alloy, such as FeAI.

For an embodiment of the second main implementation, the electric voltage source is configured and arranged to provide an initial out-of-plane electrical poling of the ferroelectric substrate to make the magnetoelectric element prepared for being induced to the OFF state when a determined electric voltage is applied by the electric voltage source.

The magnetoelectric element has respective X and Y lateral dimensions below 30 µm (any shape) and a thickness equal or larger than 2 nm, for an embodiment of the second main implementation of the magnetoelectric device of the first aspect of the present invention.

The magnetoelectric device of the first aspect of the invention comprises for an embodiment:
- an ordered array of magnetoelectric elements including the magnetoelectric element described above (for any of its implementations and embodiments) and further magnetoelectric elements which are as said magnetoelectric element; and
- an interconnection arrangement electrically connecting at least part of the magnetoelectric elements of the array and the electric voltage source, wherein the electric voltage source is configured and arranged to induce on at least some of the magnetoelectric elements, at room temperature, said ON-OFF states and OFF-ON states magnetic transitions, by selectively applying or removing said determined electric voltages thereto.

For a variant of said embodiment, the magnetoelectric device implements a magnetoelectric random access memory (ME-RAM) device, wherein each of the magnetoelectric elements of the ordered array is a free or pinned layer of a corresponding magnetic tunnel junction of a memory unit.

For some embodiments, the magnetoelectric element is in the form of a continuous film. However for other embodiments, it is in the form patterned "dots", or separate elements, forming part of the above mentioned array by being electrically interconnected using different paths. This allows for the use of this effect to implement ME-RAM device architectures (*e.g.,* crossbar geometries) suitable for several uses.

A second aspect of the present invention relates to different uses of the magnetoelectric device of the first aspect of the present invention:
- to implement a data security device using either a rigid or a flexible substrate or support for the magnetoelectric element or array of magnetoelectric elements, or
- for information and communications technologies, including neuromorphic computing and/or stochastic data storage and/or stochastic data processing.

The uses related to neuromorphic computing or stochastic data storage and processing (*i.e.,* computing) benefit from the above mentioned ME-RAM device architectures.

Specifically, the stochastic data processing can benefit from local variations in the threshold voltage values to induce ON-OFF magneto-ionic transitions in the different memory units due to uncontrolled (*i.e.,* not completely reproducible) manufacturing processes. This is the working principle of devices for "physical unclonable functions" and "true random number generators" [T. McGrath et al., A PUF taxonomy, Appl. Phys. Rev. 6 (2019) 011303], which constitute ultra-secure hardware solutions compared to conventional software cryptographic methods, which utilize complex algorithms that require additional data and increased power consumption, thus potentially reducing cost-efficiency.

### BRIEF DESCRIPTION OF THE FIGURES

In the following some preferred embodiments of the invention will be described with reference to the enclosed figures. They are provided only for illustration purposes without however limiting the scope of the invention.

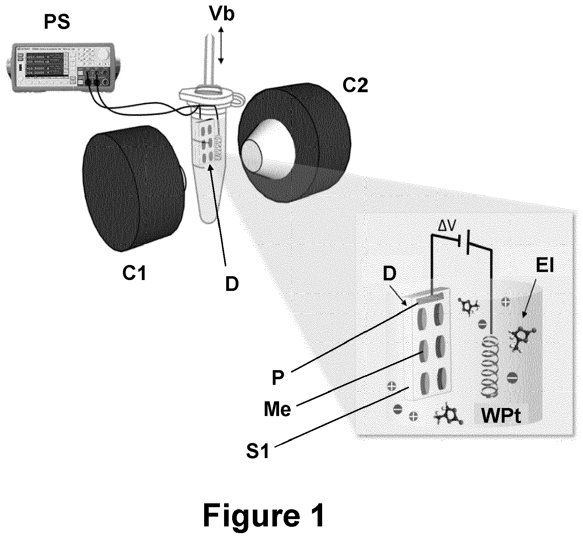

Figure 1: Experimental setup used to measure the magnetoelectric properties of the patterned structures or dots, *i.e.* of magnetoelectric elements Me, of the magnetoelectric device D (called "sample" below) of the first aspect of the present invention, in liquid configuration. It consists of a home-made electrochemical cell, where the sample/device D acts as working electrode and a Pt spiral as counter electrode WPt. An anhydrous electrolyte EI (propylene carbonate with dissolved Na⁺ ions) is utilized to prevent oxidation of the sample D upon electrical polarization of the solution. This electrolyte EI also allows the formation of the electric double layer when voltage is applied. The setup can be assembled with a vibrating sample magnetometer Vb (to measure the magnetic signal of the whole array of dots Me while voltage is applied) or with a magneto-optic Kerr effect setup, to locally measure a single dot.

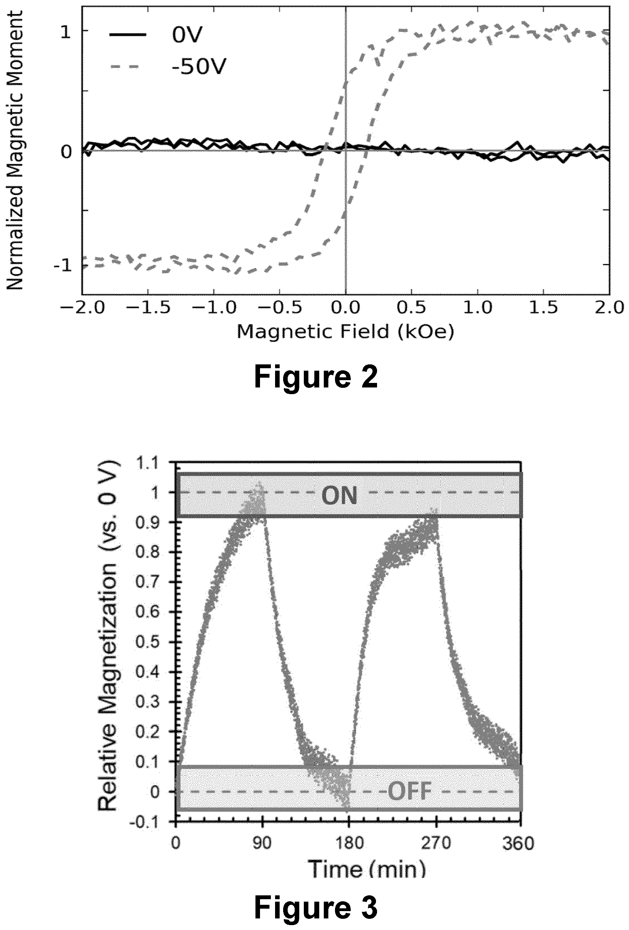

Figure 2: Normalized hysteresis loops from FeOₓ disks in the as-prepared state (ΔV = 0 V) and while applying a voltage ΔV = -50 V.
Figure 3: Variation of the normalized magnetization with time for FeOₓ during two consecutive cycles, first applying ΔV = -10 V (to induce the "ON" state) and then ΔV = +10V (to induce the OFF state).

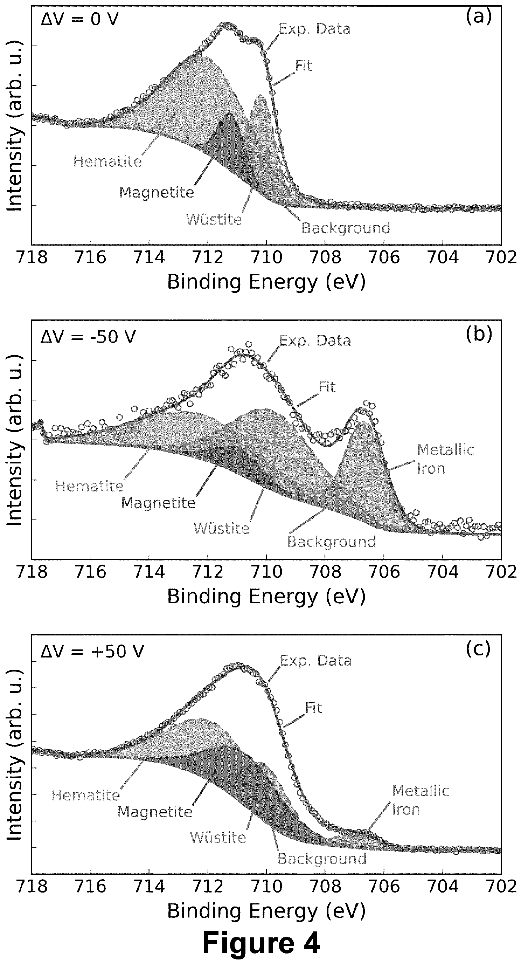

Figure 4: X-ray photoelectron spectroscopy (XPS) spectra of the 2p_{3/2} Fe peaks of the FeOₓ disks in (a) the pristine state (ΔV = 0 V), (b) after applying a negative voltage (ΔV = -50 V) and (c) after subsequently applying a positive voltage (ΔV = 50 V). The experimental data has been fitted using the convolution of the peaks corresponding to different Fe oxide phases (hematite, magnetite, wüstite) and metallic Fe.

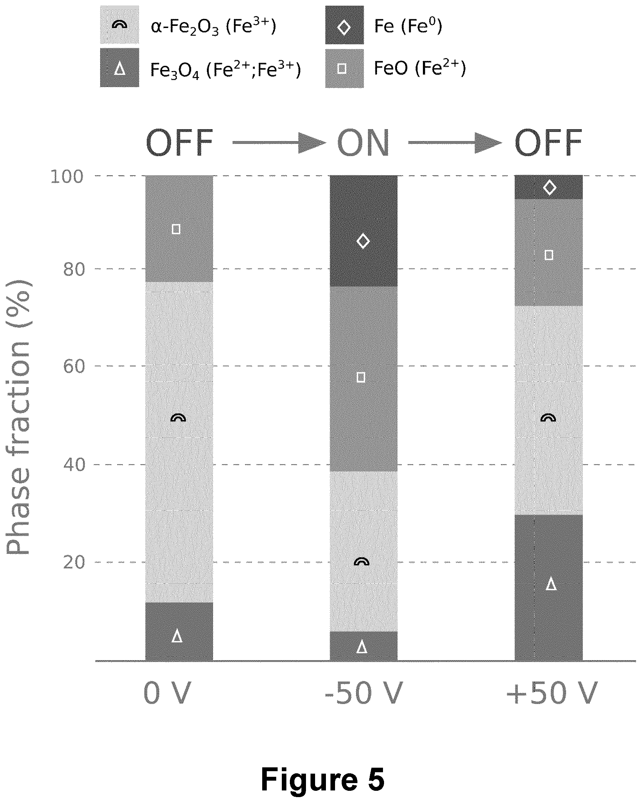

Figure 5: Quantitative assessment of the phase percentages (α-Fe₂O₃: hematite, Fe₃O₄: magnetite, Fe_{1-y}O_{y}: wüstite, Fe⁰: metallic iron), obtained from the fits of the X-ray photoelectron spectroscopy (XPS) spectra, of FeOₓ disks, at 0 V (OFF state), after applying ΔV = -50 V ("ON" state) and after subsequently applying ΔV = +50 V (partial-OFF state, in which 80% of the magnetization was removed during the time a given voltage was applied).

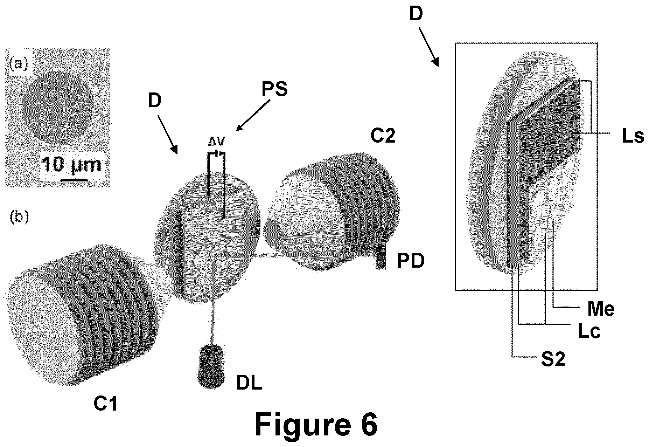

Figure 6: (a) Scanning electron microscopy (SEM) image of a Fe₇₅Al₂₅ (at. %) dense disk grown onto a lead magnesium niobate-lead titanate [PbMg1/3Nb2/3O₃-32% PbTiOs (PMN-PT)] [001] single crystal substrate S2 by sputtering, in combination with optical lithography and photoresist lift off. (b) Custom-made setup (magneto-optic Kerr effect, MOKE) used to measure the hysteresis loops of this disk while applying different voltage values.

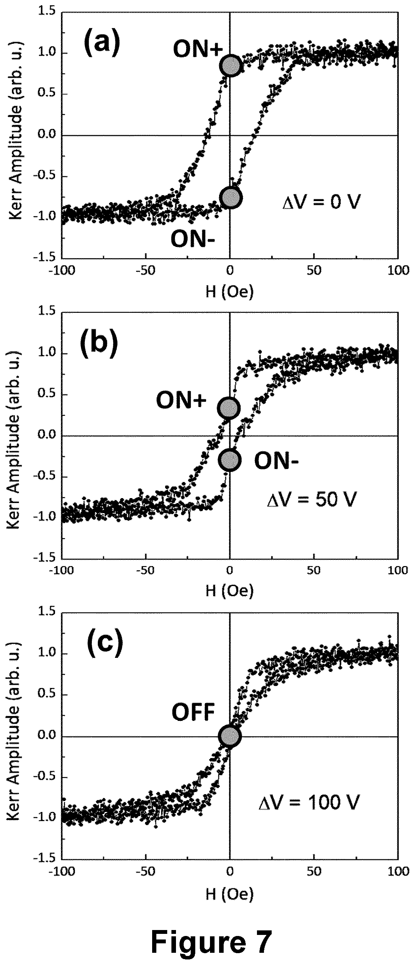

Figure 7: Hysteresis loops of a Fe₇₅Al₂₅ (at. %) disk (25 µm in diameter), grown onto a [110]-oriented ferroelectric lead magnesium niobate-lead titanate [PbMg1/3Nb2/3O₃-32% PbTiOs (PMN-PT)] single crystal, at (a) ΔV = 0 V (pristine state), (b) ΔV = + 50 V and (c) ΔV = + 100 V. In the latter two cases, the sample was first brought to ΔV = -200 V to pole the ferroelectric substrate. Note that while two different remanent states are clearly observed at 0 V and +50 V, only one state is obtained after applying ΔV = +100 V (*i.e.,* corresponding to a vortex-like hysteresis loop).

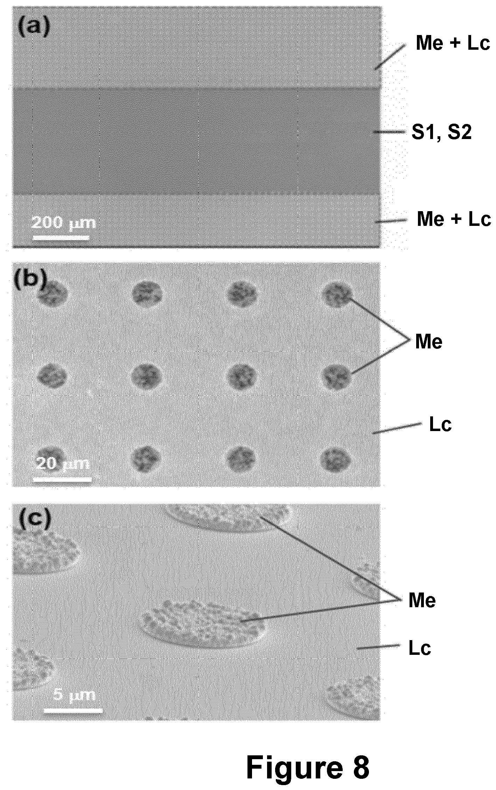

Figure 8: (a) Scanning electron microscopy (SEM) image showing two arrays of interconnected dots (through the underlying electrically conductive Cu layer) separated by a trench for electrical isolation (in which the Si/SiO₂ substrate was not coated with Cu, i.e. using a shadow mask). (b) Top SEM view image of an enlarged area of one of the magnetoelectrically actuated array of dots. (c) Tilted SEM view of the array of magnetoelectrically actuated disks.

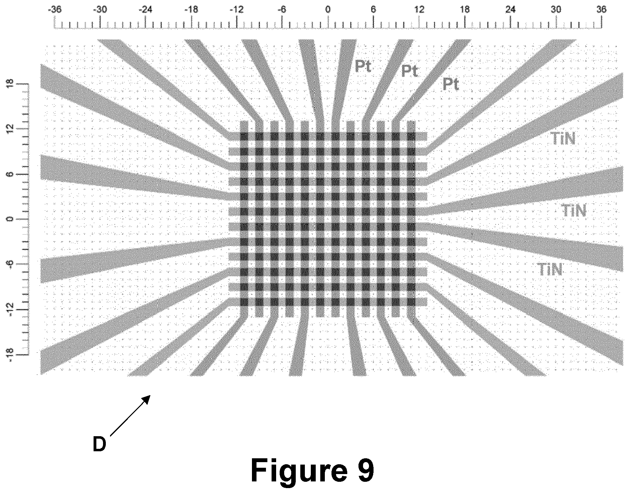

Figure 9: Crossbar arrangement that can be prepared using a sequential deposition method that combines standard optical lithography techniques.

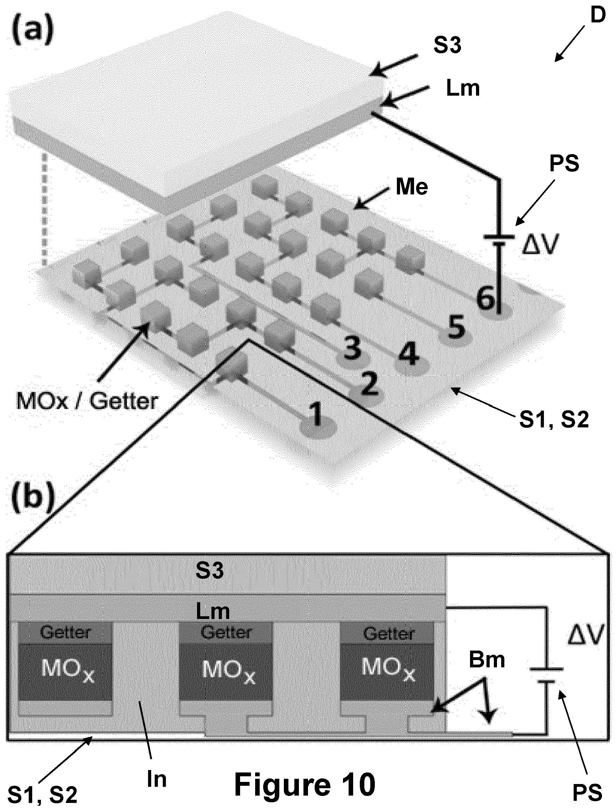

Figure 10: A solid-state magnetoelectric storage device which consists of an ordered array of micro/nano-scale transition-metal oxide (MOₓ) interconnected dots, each of them in direct contact with an oxygen getter/donor layer (*e.g.,* Gd, which will become GdOₓ upon voltage application) deposited below these dots to either provide or accept oxygen upon voltage application (depending on the voltage polarity). The dots can be electrically connected in a combinatorial fashion, *i.e.,* using different paths, therefore, forming a number of possible circuits. Voltage (ΔV) will be applied only to pre-selected dots belonging to an activated path (*e.g.,* circuit '6'). By applying ΔV, the pre-selected disks will undergo transitions from antiferromagnetic (or paramagnetic) to ferromagnetic (or ferrimagnetic) states. Metal paths can be made of metals such as Cu, Pt or Au.

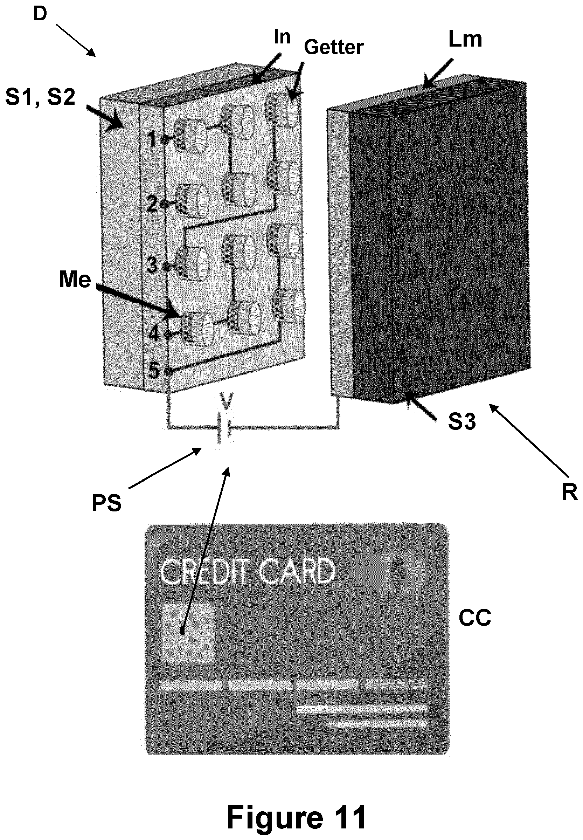

Figure 11: Concept/configuration of a voltage-actuated multi-element security memory device to be used in anti-counterfeiting technologies (*e.g.,* smart chips in credit cards).

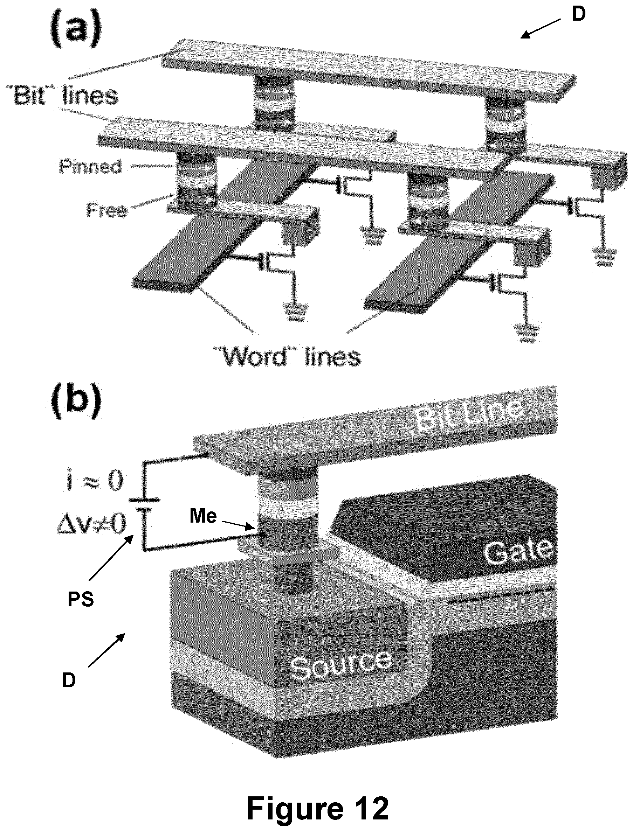

Figure 12: (a) Schematic drawing of the magnetoelectric device of the first aspect of the present invention implementing a magnetic random-access memory (MRAM) device in which each magnetic unit consists of a magnetic tunnel junction coupled to complementary-metal-oxide semiconductor (CMOS) transistor. (b) Writing operation principle in a voltage-driven MRAM using the magnetoelectric element of the magnetoelectric device as a free layer in the magnetic tunnel junctions.

### DESCRIPTION OF THE PREFERRED EMBODIMENTS

In the present section some working embodiments of the present invention will be described with reference to the Figures.

In a previous section first and second main implementations of the magnetoelectric device of the first aspect of the present invention have been described, based on two different physical mechanisms, to induce ON-OFF (or OFF-ON) magnetic transitions, at room temperature, in one or more magnetoelectric elements, by means of applying or removing determined electric voltages, of given polarities.

In the present section, those first and second main implementations will be described with more detail, and experiments carried out by the present inventors will be described for both of said first and second main implementations.

For the first main implementation, as stated above, voltage is used to induce a controlled migration of ions (e.g., oxygen or nitrogen) in one or more magnetic elements of certain metal oxide or nitride patterned structures. This effect is referred to as "magneto-ionics". Such migration induces a transition from antiferromagnetic phases (with zero or negligible magnetic moment) to ferromagnetic phases (with a certain net magnetization that can be tuned with voltage). The effect is here demonstrated in FeOx disks (8 µm in diameter) prepared from continuous films grown by evaporation induced self-assembly and subsequently patterned by optical lithography plus selective etching. The typical thickness of the FeOₓ layer is 100 nm and it exhibits a 25% porosity degree with an average ligament size of around 20 nm. Magnetoelectric measurements are performed using vibrating sample magnetometry (VSM) while applying voltage in a home-made setup. Anhydrous propylene carbonate, a liquid electrolyte, is used as a means to generate an electric double layer which conformally coats the surface when voltage is applied. Starting from a virtually non-magnetic OFF state (magnetization below the threshold of detection), a clear ferromagnetic-like hysteresis loop (ON state) is obtained when a negative voltage is applied. The generated signal is proportional to the applied voltage and progressively increases with the time voltage is applied. Such ON state can be reversed (magnetism can be essentially deleted) by subsequently applying a sufficiently high positive voltage. The cycling process can be repeated several times, demonstrating reasonably good endurance. This magnetic phase transition is related to oxygen migration (from the sample to the electrolyte during negative voltage and vice versa for positive voltage), which causes reversible phase transformations. In particular, metallic iron phase is formed when negative voltage is applied (providing finite magnetization), while it reoxidizes when positive voltage is applied (reducing the magnetization). Slight changes in the amounts of oxides depending on the applied voltage and time can be quantified by using X-ray photoelectron spectroscopy. Similar effects can be induced in sputtered CoN and FeN, where magneto-ionics is driven by voltage-induced nitrogen ion migration, instead of oxygen migration.

In the first main implementation of the first aspect of the present invention, a magneto-ionic OFF-ON effect is demonstrated in circular disks consisting of FeOₓ. First, FeOₓ films are prepared by the evaporation-induced self-assembly (EISA) method. Then, the films are patterned by optical lithography followed by chemical etching. The complete technical details and processing conditions are as follows. To grow the films, a sol-gel is first obtained by dissolving 400 mg FeCl₂·4H₂O and 380 mg citric acid (1:1 molar ratio) in 10 ml of ethanol absolute. The solution is stirred for 48 h at 500 rpm at room temperature. Sputtered Pt thin film (70 nm in thickness) onto Si chips serve as substrates for the FeOₓ films deposition. The Si/Pt substrates are cleaned in oxygen plasma and soaked in 0.4 M KOH solution (1:1 water:ethanol mixed solvent) for 5 min to increase sol-gel wettability. The FeOₓ thin film is obtained by dip-coating technique, using a withdrawal rate of 300 mm/min in a Coater 5 AC from id Lab at room temperature and 50 % relative humidity. After dip-coating, the samples are promptly transferred to the hot plate at 100°C to assist fast solvent evaporation. Accumulated thickness of the FeOₓ layers can be realized by iterating this cycle, i.e., for 100 nm thick film, the dipping process is repeated 3 times gently annealing the layers at 100°C for 10 min after dipping. As a final step, the samples are annealed at 600°C for 3 h in air atmosphere to crystalize the oxide. Patterning of the arrays of FeOₓ microdisks are then obtained by a conventional microfabrication sequence, consisting in photolithography and selective chemical etching processes. The photoresist patterned as an array of circles of 10 µm in diameter is used as mask in the chemical etching. Wet chemical etchant consists in concentrated HCl acid (12 M) and is able to remove unmasked FeOₓ in approximately 14 min, selectively, i.e., both photoresist and Pt film are unaffected. The photoresist mask is, then, removed by immersing the samples in dimethyl sulfoxide (DMSO) for 45 min, followed by a final gentle rising in acetone, isopropanol and Milli-Q water. In a similar fashion, arrays of CoN and FeN disks can be prepared combining e.g. reactive sputtering and optical lithography processing or sequence.

For the embodiment of this first main implementation shown in Figure 1, *in-situ* magnetoelectric measurements are performed on the assembly of patterned dots (i.e., magnetoelectric elements Me) using a MicroSense (LOT-QuantumDesign) Vibrating Sample Magnetometer (VSM) (see Figure 1), for by magnetic field coils C1, C2 to provide a vibration to the device D according to direction Vb. The voltage is applied using an Agilent B2902A power supply PS through a home-made electrochemical cell attached to the VSM holder. The FeOₓ sample, or device D, acts as a cathode and the contact is made to an underlying Pt seed layer (not shown) of a substrate S1, in this case via an accessible electrically conductive pad P. A Pt wire is the counter electrode WPt. The two electrodes are placed parallel to each other in a small Eppendorf^{®} tube (1 mL) filled with the anhydrous propylene carbonate (PC) solution (Figure 1). The electrolyte is externally treated with metallic Na to eliminate any trace of water and thus contains a small fraction of Na⁺ (*ca.* 5 ppm) and OH⁻ ions. No other salts are added. Magnetic hysteresis loops are recorded in-plane after the voltage (negative or positive) is applied to the sample for 1 h. Apart from the FeOₓ samples, magnetic hysteresis loops are also recorded for the spare Si/Pt substrate immersed in the electrochemical cell containing of the same components as in the case of FeOₓ for recording a reference signal. Subsequently, the substrate contribution is subtracted from the magnetic hysteresis loops of FeOₓ. The magnetization versus magnetic field curve of the as-deposited disks shows no obvious hysteresis (i.e., OFF magnetism in the as-prepared state) (see Figure 2). Conversely, a clear hysteresis loop is observed after subjecting the FeOₓ to -50 V (ON state), with a magnetic moment at saturation of 24 µemu. It is worth mentioning that, depending on the EISA conditions, the magnetic state of the pristine FeOₓ disks (before applying any voltage) can be varied and hysteresis loops with low saturation magnetization can also be obtained. In that case, application of the negative voltage also induces a measurable increase of the magnetic moment. Remarkably, the effects of the negative voltage can be reversed by applying a positive voltage (of certain magnitude and time duration). Figure 3 shows how the saturation magnetization of the FeOₓ disks can be increased and then decreased, two times consecutively, applying alternating values of negative (ΔV = -10 V) and positive (ΔV = +10 V), respectively. The changes in magnetic moment are not absolute or discrete, but can take intermediate values depending on the time and voltage value that is used. This analog variation of the magnetization, with applied voltage and time, can be the basis for the use of this technology and procedure in neuromorphic computing.

To unravel the mechanism which governs the OFF-ON magnetic transition, X-ray photoelectron spectroscopy (XPS) can be used. Given the need for ultra-high vacuum environment during XPS experiments, the effect of the magnetoelectric actuation has to be analysed *ex-situ,* after voltage has been applied and outside the electrochemical cell setup. The XPS spectra (Figure 4) reveal that the pristine FeOₓ disks consist of a mixture of iron oxide phases (hematite, wüstite and magnetite). The relative percentages of the different oxides are given in Figure 5. Note that while magnetite (which is ferrimagnetic in bulk form) is present in the as-prepared state, no hysteresis loop can be measured at ΔV = 0 V (Figure 2), suggesting that this phase is mainly in the form of small superparamagnetic nanoclusters, so that they do not give rise to any hysteresis and the attainable magnetization is below the detection limit of the technique. Remarkably, XPS spectra reveal that when a negative voltage (ΔV = -50 V) is applied, a fraction of metallic iron forms. This can explain the emergence of the ferromagnetic behavior (ON state). After positive voltage (ΔV = +50 V) is applied, metallic iron re-oxidizes, and the FeOₓ disks become again a mixture of oxide phases. Note that XPS is a surface-sensitive technique, so the overall phase percentages given in Figure 5 should be taken with certain caution.

The second main implementation of the first aspect of the present invention relates to the use of voltage to induce transitions in the reversal mode of patterned ferromagnetic structures, at room temperature, when deposited onto ferroelectric substrate (piezo-strain mediated magnetic transitions). More specifically, a transition from ferromagnetic states (square hysteresis loops with two clear remanent magnetization values, *i.e.* coherent rotation reversal mode) to states with zero net remanent magnetization (for example, vortex-like states) or states with very low remanent magnetization (for example, C-states or S-states) can be induced in Fe₇₅Al₂₅ (at. %) disks (25 µm in diameter, layer thickness around 50 nm, dense) deposited onto a lead magnesium niobate-lead titanate [PbMg1/3Nb2/3O₃-32% PbTiOs (PMN-PT)] [001] single crystal by sputtering. Imprinting of ferroelectric domains to the ferromagnetic Fe₇₅Al₂₅ layer is at the heart of the observed effects.

For the second main implementation of the magnetoelectric device of the first aspect of the present invention, the magnetoelectric behaviour of an array of dense (non-mesoporous) Fe₇₅Al₂₅ (at.%) disks (20 µm in diameter, 50 nm in thickness), implementing magnetoelectric elements Me, grown onto a PMN-32PT ferroelectric [100] single-crystalline substrate S2, is investigated. These disks Me are grown by sputtering and a thin Cu film Lc is used as seed layer over the substrate S2. Patterning is performed by optical lithography and subsequent wet chemical etching, using a process analogous to that reported in the first embodiment (in this case with acetone and for two minutes in an ultra-sounds bath). In this case, the effects of voltage are not governed by ion migration (magneto-ionics) but, instead, they are mediated by piezostrain, via the coupling between the highly magnetostrictive FeAl phase and the ferroelectric substrate S2. Here, no liquid electrolyte is used during magnetoelectric measurements. Instead, the electrical contacts are made directly at both sides of the PMN-32PT crystals, in this case by corresponding silver paste portions Ls, and the Fe₇₅Al₂₅ disks are electrically charged through the underlying Cu conductive layer Lc (see Figure 6). Magnetic hysteresis loops are recorded by magneto-optic Kerr effect (MOKE), focusing the laser spot (which is about 25 µm in diameter) directly on top of the patterned disk of interest. A square hysteresis loop, with two possible remanent magnetization states ("ON +" and "ON -") is obtained in the pristine disks at ΔV = 0 V. Out-of-plane electrical poling of the ferroelectric is then performed by applying a strong negative voltage (ΔV = -200 V). Remarkably, after doing so, the hysteresis loops that are recorded while applying positive voltages (e.g., at ΔV = +50 V or ΔV = +100 V), tend to change their shape, losing their squareness and becoming progressively more constricted as the positive voltage value is increased (see Figure 7). While "ON +" and "ON -" states with lower remanent magnetization are obtained at ΔV = +50 V, a vortex-like hysteresis loop (with zero remanent magnetization, "OFF" state) is measured at ΔV = +100 V. These results show the strong influence of voltage-controlled strain on the obtained magnetic properties. Here, opposite to the magneto-ionic case described in the first embodiment, no phase transformations are induced by voltage. Instead, the existing piezostrain causes a change in the magnetization reversal mode of the patterned structures. Remarkably, the pristine Fe₇₅Al₂₅ disks are probably already under the influence of strain due to the underlying ferroelectric substrate, which has a spontaneous ferroelectric polarization. When voltage is applied, new domains form in the ferroelectric substrate, which change the strain state in the Fe₇₅Al₂₅ disks, resulting in the observed constriction of the hysteresis loops. In this context, coupling between the ferroelectric domains in PMN-32 (molar %) PT and the ferromagnetic state in Fe₇₅Al₂₅ is envisaged. Interestingly, similar to the first embodiment, the effect of voltage can also be reversed here. Hysteresis loops with two remanent states can be recovered if the applied positive voltage is further increased (*e.g.,* ΔV = +200 V) or by bringing the disks back to 0 V. The maximum constriction is thus obtained around ΔV = +100 V, which is the coercive voltage of the substrate. A notable aspect of this second embodiment is that here the magnetoelectric effects are rather instantaneous (as opposed to magneto-ionics, which required applying each voltage value for several minutes).

For an embodiment of any of the above described first and second main implementations, the magnetoelectric device of the first aspect of the present invention consists of electrically interconnecting different groups of dots (i.e. of patterned structures or magnetoelectric elements Me) of one or more arrays, in different ways, so that magnetoelectric actuation (either magneto-ionic or strain-mediated) can be performed selectively to a single dot or patterned structure Me, groups of patterned structures Me or the whole array of patterned structures Me. In the simplest example, Figure 8 shows two sub-arrays of patterned disks Me, grown onto a Cu seed layer Lc of a substrate S1, S2, separated by a rectangular region with no deposited Cu (and with no disks Me) - a shadow mask was used for such a purpose. Electric contact can be made either to the upper or to the bottom sub-arrays of disks Me, or to both simultaneously. The presence of an electrically insulating spacer region (the surface of the Si/SiO₂ substrate S1, S2 is insulating unless it is metallized with Cu), allows for this selective electrical actuation. In this way, for example, one can induce an "ON state" in the upper sub-array of dots Me and an "OFF state" in the bottom sub-array of dots Me. Or, even more interestingly, two different ON states (with different magnetization) can be obtained in the two sub-arrays of disks Me by applying different voltage values to them. This selective actuation is the basis for the utilization of this magnetoelectric effect in practical applications such as neuromorphic computing or data security devices.

Another embodiment of the magnetoelectric device of the first aspect of the present invention is related to the implementation of crossbar arrays of interconnected memory units (Figure 9). These arrays can be fabricated using a sequential deposition method that combines standard optical lithography techniques. First, a layer of photoresist is spin-coated on the Si surface and then exposed under ultraviolet light in a Micro-Writer lithography system. A developer is used to dissolve the exposed areas, where a conductive layer of *e.g.* TiN is grown by reactive sputtering. Next, the unexposed areas are lifted off using acetone, thus resulting in the patterning of the bottom electrodes. Subsequently, the layers of interest (i.e., those comprised in the multi-stack memory units) are sputtered. Then, the pads of bottom electrode (e.g., TiN plus the multi-stack comprising the magnetic layers) are exposed through lithography and wet etching. Finally, an upper Pt electrode is patterned employing similar optical lithography protocols, defining the perpendicular crossbar structure.

A further embodiment of the magnetoelectric device of the first aspect of the present invention is shown in Figure 10. In this case, a solid-state magnetoelectric storage device is depicted, which consists of an ordered array of micro/nano-scale transition-metal oxide (MOₓ) interconnected dots Me arranged over a substrate S1 S2, each of the interconnected dots Me being in direct contact with an oxygen getter/donor layer (*e.g.,* Gd, which will become GdOₓ upon voltage application) deposited below these dots Me to either give or accept oxygen upon voltage application (depending on the voltage polarity). These dots Me can be electrically connected using different paths, through corresponding metal elements Bm, forming various possible circuits. An electrically insulating material In is arranged between and under the dots Me. For example, as illustrated in Figure 10, voltage (ΔV) can be applied only to pre-selected dots Me belonging to an activated path (*e.g.,* circuit '6'). By applying ΔV between the selected metal element(s) Bm and a metal layer Lm attached to an insulating substrate S3, the pre-selected disks will undergo transitions from antiferromagnetic to ferromagnetic states (magneto-ionic effect) or from coherent rotation to vortex-like hysteresis loops (strain-mediated magnetoelectric effect). In this device, voltage is directly used to write "ON" or "OFF" bits of information in each magnetic memory unit.

One of the possible uses of the second aspect of the present invention, for which the magnetoelectric device D of the first aspect of the invention, for the embodiment shown in Figure 10, is used. In this case the presence or absence of magnetic signal in the memory units including magnetoelectric elements Me of the embodiment of Figure 10 can be read using a magnetic sensor. This effect constitutes the basis of a secure keycard (similar to those employed to open the doors of rooms in a hotel). The sensor reads the ON state (with either positive or negative saturation magnetization) as "1" and the OFF state as "0". Since these states are written with voltage and not with magnetic field, this offers an enhanced degree of robustness compared to conventional magnetic keycards, which can be easily demagnetized in the proximity of a permanent magnet. Different passwords can be established in these keycards, each of them activating or deactivating different collections of pre-selected memory units with voltage. A similar device architecture can be utilized to implement prototypes of smart cards in high-security identification or credit cards CC (Figure 11), by means of a spatially-resolved magnetic sensor R with spatial resolution, and having an insulating substrate S3 with a metal layer Lm facing the memory units.

Finally, Figure 12 shows an embodiment of the magnetoelectric device D of the first aspect of the present invention, for implementing a magnetoelectric MRAM (ME-RAM) device comprising a plurality of memory units including respective magnetoelectric elements Me for implementing their free layers, and the electrical interconnection between those magnetoelectric elements or disks Me (in this case using a crossbar geometry). Here, the magnetic properties of the free layer contained in each memory unit (the so-called magnetic tunnel junction, MTJ) are manipulated using voltage instead of high-intensity spin-polarized currents, as opposed to STT-RAM devices. The saturation magnetization of the free layer can be either increased or decreased with voltage (eventually it can be brought to zero) if the mechanism governing the magnetoelectric actuation is the ion migration or, alternatively, the reversal mode of the free layer can be changed from coherent rotation to vortex (or *vice versa*) if its magnetoelectric behavior is strain-mediated. In all cases, this will result in changes in the magnetoresistance which can be detected during the reading operation of the ME-RAM. As a final application, it is proposed that such ME-RAM devices can be used as "physical unclonable function" (PUF) systems for enhanced data protection hardware solutions. By setting all memory units to the same state, variations in the magnetoresistance would still be detectable when comparing the readings from different MTJs, due to uncontrolled microstructural variations within the layers not addressable during the manufacturing process. This would allow to set a series of "challenges-responses" pairs, a procedure known as PUF authentication [T. McGrath et al., A PUF taxonomy, Appl. Phys. Rev. 6 (2019) 011303]. Another property that could serve as the basis for these PUF ME-RAMs is the critical threshold voltage to induce the ON-OFF (or OFF-ON) magnetic transitions, which will be slightly different for each magnetic memory unit due to manufacturing variations. By applying a voltage very close to the nominal threshold voltage, a stochastic (*i.e.,* random) transition between ON and OFF states (or between states with different magnetization) will occur. This could be the principle for stochastic data processing or stochastic computing.

A person skilled in the art could introduce changes and modifications in the embodiments described without departing from the scope of the invention as it is defined in the attached claims.

## Claims

1. A magnetoelectric device (D), comprising:
- a magnetoelectric element (Me); and
- an electric voltage source (PS) configured and arranged to induce on said magnetoelectric element (Me), at least at room temperature, ON-OFF states and OFF-ON states magnetic transitions, by applying or removing determined electric voltages, wherein at said ON state the magnetoelectric element (Me) shows permanent and net magnetization;
wherein the magnetoelectric element (Me) is configured and arranged to be, at said induced OFF state, completely antiferromagnetic or partially antiferromagnetic but with a magnetization below 50 emu/cm³;
wherein the magnetoelectric element (Me) and the electric voltage source (PS) are configured and arranged to induce said ON-OFF states and OFF-ON states magnetic transitions by phase transformations caused by a voltage-driven ion migration mechanism;
**characterized in that** the magnetoelectric element (Me) is made of an oxide or nitride of iron, nickel, ternary nickel-cobalt or ternary cobalt-manganese,
and **in that** said magnetoelectric element (Me) is in the form of a dense layer of thickness between 2 and 200 nm, and the magnetoelectric device (D) further comprises:
- an electrically conducting substrate (S1) or a substrate (S1) with an electrically conducting buffer/seed layer (Lc); and
- a top electrode (P) configured and arranged to act as ion reservoir and/or electric contact.

2. The magnetoelectric device (D) according to claim 1, wherein the magnetoelectric element (Me) is an iron oxide comprising, when no voltage is applied thereto, hematite, wüstite or a mixture of hematite and wüstite iron oxide phases, and wherein the magnetoelectric element (Me) and the electric voltage source (PS) are configured and arranged to induce phase transformations including:
- for the ON state, metallic iron and/or magnetite; and
- for the OFF state, said hematite and wüstite iron oxide phases, and no metallic iron, no magnetite and no maghemite or a rather small fraction of metallic iron and magnetite providing said magnetization below 50 emu/cm³.

3. A magnetoelectric device (D) comprising:
- a magnetoelectric element (Me); and
- an electric voltage source (PS) configured and arranged to induce on said magnetoelectric element (Me), at least at room temperature, ON-OFF states and OFF-ON states magnetic transitions, by applying or removing determined electric voltages, wherein at said ON state the magnetoelectric element (Me) shows permanent and net magnetization;
wherein the magnetoelectric element (Me) is configured and arranged to be, at said induced OFF state, completely antiferromagnetic or partially antiferromagnetic but with a magnetization below 50 emu/cm³;
**characterized in that** the magnetoelectric device (D) further comprises a ferroelectric substrate (S2) supporting the magnetoelectric element (Me), and **in that** the magnetoelectric element (Me) and the electric voltage source (PS) are configured and arranged to induce said ON-OFF states and OFF-ON states magnetic transitions by reversal mode changes caused by a mechanism providing a voltage-driven piezostrain-mediated coupling between the ferroelectric substrate (S2) and the magnetoelectric element (Me), wherein said reversal mode changes refer to changes from/to a ferromagnetic state with multi- or single-domain state, for said ON state, to/from a state with a closure domain with minimal squareness below 10% for said OFF state.

4. The magnetoelectric device (D) according to claim 3, wherein said ferromagnetic state corresponds to either a multi- or a single-domain state, and wherein said state with minimal squareness is a flux-closure domain structure where magnetization is symmetrically distributed in-plane with respect to the flux-closure domain structure core, allowing for a maximum remanent magnetization M_{R} of 10% of the saturation magnetization Ms in case the flux-closure domain structure core is offset from the magnetoelectric element (Me) centre.

5. The magnetoelectric device according to claim 3 or 4, wherein said electric voltage source (PS) is configured and arranged to apply said determined electric voltages perpendicularly to a surface of the ferroelectric substrate (S2) facing said magnetoelectric element (Me) and to the plane of the magnetoelectric element (Me) via a condenser-like configuration through which an in-plane voltage-induced strain is produced under the out-of-plane application of said determined electric voltages.

6. The magnetoelectric device according to any of claims 3 to 5, wherein the magnetoelectric element (Me) is made of a soft ferromagnetic material with a coercivity below 200 Oe having a large polycrystalline magnetostrictive constant λ above 100 ppm.

7. The magnetization device according to claim 6, wherein said soft ferromagnetic material is a Fe-based alloy.

8. The magnetoelectric device according to any of claims 3 to 7, wherein the electric voltage source (PS) is configured and arranged to provide an initial out-of-plane electrical poling of the ferroelectric substrate (S2) to make the magnetoelectric element (Me) prepared for being induced to the OFF state when a determined electric voltage is applied by the electric voltage source (PS).

9. The magnetoelectric device according to any of claims 3 to 8, wherein said magnetoelectric element (Me) has respective X and Y lateral dimensions below 30 µm and a thickness equal or larger than 2 nm.

10. The magnetoelectric device (D) according to any of the previous claims, comprising:
- an ordered array of magnetoelectric elements (Me) including said magnetoelectric element (Me) and further magnetoelectric elements which are as said magnetoelectric element (Me); and
- an interconnection arrangement electrically connecting at least part of the magnetoelectric elements (Me) of the array and the electric voltage source (PS), wherein the electric voltage source (PS) is configured and arranged to induce on at least some of the magnetoelectric elements (Me), at room temperature, said ON-OFF states and OFF-ON states magnetic transitions, by selectively applying or removing said determined electric voltages thereto.

11. The magnetoelectric device (D) according to claim 10, wherein it implements a magnetoelectric random access memory (ME-RAM) device, wherein each of said magnetoelectric elements (Me) of the ordered array is a free or pinned layer of a corresponding magnetic tunnel junction of a memory unit.

12. Use of the magnetoelectric device (D) according to any of the previous claims:
- to implement a data security device using either a rigid or a flexible substrate or support for the magnetoelectric element (Me) or array of magnetoelectric elements (Me), or
- for information and communications technologies, including neuromorphic computing and/or stochastic data storage and/or stochastic data processing.

## Patentansprüche

1. Magnetoelektrische Vorrichtung (D), umfassend:
- ein magnetoelektrisches Element (Me); und
- eine elektrische Spannungsquelle (PS), die konfiguriert und angeordnet ist, auf dem magnetoelektrischen Element (Me), zumindest bei Raumtemperatur, durch Anlegen oder Entfernen bestimmter elektrischer Spannungen EIN-AUS-Zustände und AUS-EIN-Zustände magnetischer Übergänge zu induzieren, wobei das magnetoelektrische Element (Me) im EIN-Zustand permanente und Nettomagnetisierung zeigt;
wobei das magnetoelektrische Element (Me) so konfiguriert und angeordnet ist, dass es im induzierten AUS-Zustand vollständig antiferromagnetisch oder teilweise antiferromagnetisch, jedoch mit einer Magnetisierung unter 50 emu/cm³, ist;
wobei das magnetoelektrische Element (Me) und die elektrische Spannungsquelle (PS) konfiguriert und angeordnet sind, die EIN-AUS-Zustände und AUS-EIN-Zustände magnetischer Übergänge durch Phasenübergänge, die durch einen spannungsgetriebenen Ionenmigrationsmechanismus bewirkt werden, zu induzieren,
**dadurch gekennzeichnet, dass** das magnetoelektrische Element (Me) aus einem Oxid oder einem Nitrid von Eisen, Nickel, ternärem Nickel-Kobalt oder ternärem Kobalt-Mangan hergestellt ist,
und dass das magnetoelektrische Element (Me) in der Form einer dichten Schicht mit einer Dicke im Bereich von 2 bis 200 nm vorliegt und die magnetoelektrische Vorrichtung (D) ferner umfasst:
- ein elektrisch leitendes Substrat (S1) oder ein Substrat (S1) mit einer elektrisch leitenden Puffer/Saat-Schicht (Lc); und
- eine obere Elektrode (P), die konfiguriert und angeordnet ist, als Ionenspeicher und/oder als elektrischer Kontakt zu wirken.

2. Magnetoelektrische Vorrichtung (D) nach Anspruch 1, wobei das magnetoelektrische Element (Me) ein Eisenoxid ist, das dann, wenn keine Spannung daran angelegt ist, Hämatit, Wüstit oder ein Gemisch aus Hämatit- und Wüstit-Eisenoxidphasen umfasst, und wobei das magnetoelektrische Element (Me) und die elektrische Spannungsquelle (PS) konfiguriert und angeordnet sind, Phasenübergänge zu induzieren, die enthalten:
- für den EIN-Zustand metallisches Eisen und/oder Magnetit, und
- für den AUS-Zustand die Hämatit- und Wüstit-Eisenoxidphasen und kein metallisches Eisen, keinen Magnetit und keinen Maghämit oder einen eher kleinen Anteil von metallischem Eisen und Magnetit, der die Magnetisierung unter 50 emu/cm³ bereitstellt.

3. Magnetoelektrische Vorrichtung (D), umfassend:
- ein magnetoelektrisches Element (Me); und
- eine elektrische Spannungsquelle (PS), die konfiguriert und angeordnet ist, auf dem magnetoelektrischen Element (Me), zumindest bei Raumtemperatur, durch Anlegen oder Entfernen bestimmter elektrischer Spannungen EIN-AUS-Zustände und AUS-EIN-Zustände magnetischer Übergänge zu induzieren, wobei das magnetoelektrische Element (Me) im EIN-Zustand permanente und Nettomagnetisierung zeigt;
wobei das magnetoelektrische Element (Me) so konfiguriert und angeordnet ist, dass es im induzierten AUS-Zustand vollständig antiferromagnetisch oder teilweise antiferromagnetisch, jedoch mit einer Magnetisierung unter 50 emu/cm³, ist;
**dadurch gekennzeichnet, dass** die magnetoelektrische Vorrichtung (D) ferner ein ferroelektrisches Substrat (S2) umfasst, das das magnetoelektrische Element (Me) trägt, und dass das magnetoelektrische Element (Me) und die elektrische Spannungsquelle (PS) konfiguriert und angeordnet sind, die EIN-AUS-Zustände und AUS-EIN-Zustände magnetischer Übergänge durch umkehrbare Modusänderungen zu induzieren, die durch einen Mechanismus bewirkt werden, der eine spannungsgetriebene, durch Piezogitterdeformation vermittelte Kopplung zwischen dem ferroelektrischen Substrat (S2) und dem magnetoelektrischen Element (Me) bereitstellt, wobei sich die umkehrbaren Modusänderungen auf Änderungen aus einem/in einen ferromagnetischen Zustand mit Mehrfach- oder Einfachdomänenzustand für den EIN-Zustand, in einen/aus einem Zustand mit einer Einschlussdomäne mit einer minimalen Rechtwinkligkeit unter 10 % für den AUS-Zustand beziehen.

4. Magnetoelektrische Vorrichtung (D) nach Anspruch 3, wobei der ferromagnetische Zustand entweder einem Mehrfachdomänenzustand oder einem Einfachdomänenzustand entspricht und wobei der Zustand mit minimaler Rechtwinkligkeit eine Flusseinschluss-Domänenstruktur ist, in der die Magnetisierung in Bezug auf den Kern der Flusseinschluss-Domänenstruktur symmetrisch in derselben Ebene verteilt ist, wobei eine maximale remanente Magnetisierung M_{R} von 10 % der Sättigungsmagnetisierung Ms ermöglicht wird, falls der Kern der Flusseinschluss-Domänenstruktur von der Mitte des magnetoelektrischen Elements (Me) versetzt ist.

5. Magnetoelektrische Vorrichtung nach Anspruch 3 oder 4, wobei die elektrische Spannungsquelle (PS) konfiguriert und angeordnet ist, die bestimmten elektrischen Spannungen senkrecht zu einer Oberfläche des ferroelektrischen Substrats (S2), die dem magnetoelektrischen Element (Me) zugewandt ist, und zu der Ebene des magnetoelektrischen Elements (Me) über eine kondensatorartige Konfiguration anzulegen, durch die unter dem Anlegen der bestimmten elektrischen Spannungen außerhalb der Ebene eine spannungsinduzierte Gitterdeformation in der Ebene erzeugt wird.

6. Magnetoelektrische Vorrichtung nach einem der Ansprüche 3 bis 5, wobei das magnetoelektrische Element (Me) aus einem weichferromagnetischen Material mit einer Koerzitivfeldstärke unter 200 Oe hergestellt ist, das eine große polykristalline magnetostriktive Konstante λ über 100 ppm aufweist.

7. Magnetisierungsvorrichtung nach Anspruch 6, wobei das weichferromagnetische Material eine Fe-basierte Legierung Fe ist.

8. Magnetoelektrische Vorrichtung nach einem der Ansprüche 3 bis 7, wobei die elektrische Spannungsquelle (PS) konfiguriert und angeordnet ist, eine anfängliche elektrische Polung außerhalb der Ebene des ferroelektrischen Substrats (S2) bereitzustellen, um zu bewirken, dass das magnetoelektrische Element (Me) dafür vorbereitet ist, in den AUS-Zustand induziert zu werden, wenn eine bestimmte elektrische Spannung durch die elektrische Spannungsquelle (PS) angelegt wird.

9. Magnetoelektrische Vorrichtung nach einem der Ansprüche 3 bis 8, wobei das magnetoelektrische Element (Me) jeweilige seitliche X- und Y-Abmessungen unter 30 µm und eine Dicke gleich oder größer als 2 nm aufweist.

10. Magnetoelektrische Vorrichtung (D) nach einem der vorhergehenden Ansprüche, umfassend:
- eine geordnete Anordnung magnetoelektrischer Elemente (Me), die das magnetoelektrische Element (Me) und weitere magnetoelektrische Elemente, die wie das magnetoelektrische Element (Me) sind, enthält; und
- eine Kopplungsanordnung, die zumindest einen Teil der magnetoelektrischen Elemente (Me) der Anordnung und die elektrische Spannungsquelle (PS) elektrisch verbindet, wobei die elektrische Spannungsquelle (PS) konfiguriert und angeordnet ist, zumindest auf einigen der magnetoelektrischen Elemente (Me) bei Raumtemperatur durch selektives Anlegen oder Entfernen der bestimmten elektrischen Spannungen daran die EIN-AUS-Zustände und AUS-EIN-Zustände magnetischer Übergänge zu induzieren.

11. Magnetoelektrische Vorrichtung (D) nach Anspruch 10, wobei sie eine magnetoelektrische Schreib/Lese-Speichervorrichtung (ME-RAM-Vorrichtung) implementiert, wobei jedes der magnetoelektrischen Elemente (Me) der geordneten Anordnung eine freie Schicht oder eine Pinning-Schicht eines entsprechenden magnetischen Tunnelübergangs einer Speichereinheit ist.

12. Verwendung der magnetoelektrischen Vorrichtung (D) nach einem der vorhergehenden Ansprüche:
- um unter Verwendung entweder eines starren oder eines flexiblen Substrats oder Trägers für das magnetoelektrische Element (Me) oder Anordnung magnetoelektrischer Elemente (Me) eine Datensicherheitsvorrichtung zu implementieren, oder
- für Informations- und Kommunikationstechnologien, einschließlich neuromorphes Computing und/oder stochastische Datenspeicherung und/oder stochastische Datenverarbeitung.

## Revendications

1. Dispositif magnétoélectrique (D), comprenant :
- un élément magnétoélectrique (Me) ; et
- une source de tension électrique (PS) configurée et agencée pour induire sur ledit élément magnétoélectrique (Me), au moins à température ambiante, des transitions magnétiques d'états MARCHE-ARRET et d'états ARRET-MARCHE, en appliquant ou en supprimant des tensions électriques déterminées, dans lequel, dans ledit état MARCHE, l'élément magnétoélectrique (Me) présente une magnétisation permanente et nette ;
dans lequel l'élément magnétoélectrique (Me) est configuré et agencé pour être, dans ledit état ARRET induit, complètement antiferromagnétique ou partiellement antiferromagnétique mais avec une magnétisation inférieure à 50 emu/cm³ ;
dans lequel l'élément magnétoélectrique (Me) et la source de tension électrique (PS) sont configurés et agencés pour induire lesdites transitions magnétiques d'états MARCHE-ARRET et d'états ARRET-MARCHE par des transformations de phase causées par un mécanisme de migration d'ions commandé par une tension ;
**caractérisé en ce que** l'élément magnétoélectrique (Me) est constitué d'un oxyde ou d'un nitrure de fer, de nickel, de nickel-cobalt ternaire ou de cobalt-manganèse ternaire,
et **en ce que** ledit élément magnétoélectrique (Me) se présente sous la forme d'une couche dense d'une épaisseur comprise entre 2 et 200 nm, et le dispositif magnétoélectrique (D) comprend en outre :
- un substrat électriquement conducteur (S1) ou un substrat (S1) avec une couche de tampon/germe électriquement conductrice (Lc) ; et
- une électrode supérieure (P) configurée et agencée pour agir comme réservoir d'ions et/ou contact électrique.

2. Dispositif magnétoélectrique (D) selon la revendication 1, dans lequel l'élément magnétoélectrique (Me) est un oxyde de fer comprenant, lorsqu'aucune tension n'y est appliquée, de l'hématite, de la wüstite ou un mélange de phases d'oxyde de fer d'hématite et de wüstite, et dans lequel l'élément magnétoélectrique (Me) et la source de tension électrique (PS) sont configurés et agencés pour induire des transformations de phase comprenant :
- pour l'état MARCHE, du fer métallique et/ou de la magnétite ; et
- pour l'état ARRET, lesdites phases d'oxyde de fer d'hématite et de wüstite, et pas de fer métallique, pas de magnétite et pas de maghémite ou une assez petite fraction de fer métallique et de magnétite fournissant ladite magnétisation inférieure à 50 emu/cm3.

3. Dispositif magnétoélectrique, (D) comprenant :
- un élément magnétoélectrique (Me) ; et
- une source de tension électrique (PS) configurée et agencée pour induire sur ledit élément magnétoélectrique (Me), au moins à température ambiante, des transitions magnétiques d'états MARCHE-ARRET et d'états ARRET-MARCHE, en appliquant ou en supprimant des tensions électriques déterminées, dans lequel, dans ledit état MARCHE, l'élément magnétoélectrique (Me) présente une magnétisation permanente et nette ;
dans lequel l'élément magnétoélectrique (Me) est configuré et agencé pour être, dans ledit état ARRET induit, complètement antiferromagnétique ou partiellement antiferromagnétique mais avec une magnétisation inférieure à 50 emu/cm3 ;
**caractérisé en ce que** le dispositif magnétoélectrique (D) comprend en outre un substrat ferroélectrique (S2) supportant l'élément magnétoélectrique (Me), et **en ce que** l'élément magnétoélectrique (Me) et la source de tension électrique (PS) sont configurés et agencés pour induire lesdites transitions magnétiques d'états MARCHE-ARRET et d'états ARRET-MARCHE par des changements de mode d'inversion provoqués par un mécanisme fournissant un couplage médié par contrainte piézoélectrique commandé par une tension entre le substrat ferroélectrique (S2) et l'élément magnétoélectrique (Me), dans lequel lesdits changements de mode d'inversion se réfèrent à des changements depuis/vers un état ferromagnétique avec un état multi-domaine ou mono-domaine, pour ledit état de marche, vers/depuis un état avec un domaine de fermeture avec une quadrature minimale inférieure à 10 % pour ledit état ARRET.

4. Dispositif magnétoélectrique (D) selon la revendication 3, dans lequel ledit état ferromagnétique correspond à un état multi-domaine ou mono-domaine, et dans lequel ledit état avec une quadrature minimale est une structure de domaine de fermeture de flux où la magnétisation est distribuée de manière symétrique dans le plan par rapport au noyau de structure de domaine de fermeture de flux, en permettant une magnétisation rémanente maximale M_{R} de 10 % de la magnétisation de saturation M_{S} dans le cas où le noyau de structure de domaine de fermeture de flux est décalé du centre de l'élément magnétoélectrique (Me).

5. Dispositif magnétoélectrique selon la revendication 3 ou 4, dans lequel ladite source de tension électrique (PS) est configurée et agencée pour appliquer lesdites tensions électriques déterminées perpendiculairement à une surface du substrat ferroélectrique (S2) faisant face audit élément magnétoélectrique (Me) et au plan de l'élément magnétoélectrique (Me) via une configuration de type condensateur à travers laquelle une contrainte induite par une tension dans le plan est produite sous l'application hors plan desdites tensions électriques déterminées.

6. Dispositif magnétoélectrique selon l'une quelconque des revendications 3 à 5, dans lequel l'élément magnétoélectrique (Me) est réalisé en un matériau ferromagnétique doux avec une coercivité inférieure à 200 Oe présentant une grande constante magnétostrictive polycristalline λ supérieure à 100 ppm.

7. Dispositif de magnétisation selon la revendication 6, dans lequel ledit matériau ferromagnétique doux est un alliage à base de Fe.

8. Dispositif magnétoélectrique selon l'une quelconque des revendications 3 à 7, dans lequel la source de tension électrique (PS) est configurée et agencée pour fournir une polarisation électrique hors plan initiale du substrat ferroélectrique (S2) pour amener l'élément magnétoélectrique (Me) à être préparé pour être induit à l'état ARRET lorsqu'une tension électrique déterminée est appliquée par la source de tension électrique (PS).

9. Dispositif magnétoélectrique selon l'une quelconque des revendications 3 à 8, dans lequel ledit élément magnétoélectrique (Me) présente des dimensions latérales X et Y respectives inférieures à 30 µm et une épaisseur égale ou supérieure à 2 nm.

10. Dispositif magnétoélectrique (D) selon l'une quelconque des revendications précédentes, comprenant :
- un réseau ordonné d'éléments magnétoélectriques (Me) comprenant ledit élément magnétoélectrique (Me) et d'autres éléments magnétoélectriques qui sont comme ledit élément magnétoélectrique (Me) ; et
- un agencement d'interconnexion connectant électriquement au moins une partie des éléments magnétoélectriques (Me) du réseau et la source de tension électrique (PS), dans lequel la source de tension électrique (PS) est configurée et agencée pour induire sur au moins certains des éléments magnétoélectriques (Me), à température ambiante, lesdites transitions d'états MARCHE-ARRET et d'états ARRET-MARCHE, en leur appliquant ou en supprimant sélectivement lesdites tensions électriques déterminées.

11. Dispositif magnétoélectrique (D) selon la revendication 10, dans lequel il met en oeuvre un dispositif de mémoire vive magnétoélectrique (ME-RAM), dans lequel chacun desdits éléments magnétoélectriques (Me) du réseau ordonné est une couche libre ou épinglée d'une jonction tunnel magnétique correspondante d'une unité de mémoire.

12. Utilisation du dispositif magnétoélectrique (D) selon l'une quelconque des revendications précédentes :
- pour mettre en oeuvre un dispositif de sécurité des données utilisant un substrat ou un support rigide ou flexible pour l'élément magnétoélectrique (Me) ou un réseau d'éléments magnétoélectriques (Me), ou
- pour les technologies de l'information et de la communication, incluant un calcul neuromorphique et/ou un stockage de données stochastiques et/ou un traitement de données stochastiques.
